Europäisches Patentamt

European Patent Office

Office européen des brevets

(19)

(11) Numéro de publication : **0 021 931**
**B1**

# (12) FASCICULE DE BREVET EUROPÉEN

(45) Date de publication du fascicule du brevet :
**30.03.83**

(21) Numéro de dépôt : **80400815.9**

(22) Date de dépôt : **06.06.80**

(51) Int. Cl.³ : **H 01 L 21/00**

(54) **Procédé d'auto-alignement de régions différemment dopées d'une structure de semiconducteur, et application du procédé à la fabrication d'un transistor.**

(30) Priorité : **22.06.79 FR 7916055**

(43) Date de publication de la demande :
**07.01.81 Bulletin 81/01**

(45) Mention de la délivrance du brevet :
**30.03.83 Bulletin 83/13**

(84) Etats contractants désignés :
**DE GB IT NL**

(56) Documents cités :
**DE A 2 018 027**
**DE A 2 754 066**
**FR A 1 437 781**
**FR A 2 305 022**
**US A 3 468 728**
**US A 3 920 483**
**IBM TECHNICAL DISCLOSURE BULLETIN, vol. 14, no. 9, février 1972 New York US L.M. ELIJAH et al. : « Etching Technique for minimun under-cutting » page 2607**
**PATENTS ABSTRACTS OF JAPAN, vol. 2, no. 124, 18 octobre 1978, page 7230 E 78, Tokyo, JP**
**PATENTS ABSTRACTS OF JAPAN, vol. 2, no. 129, 27 octobre 1978, page 7841 E 78, Tokyo, JP**

(73) Titulaire : **THOMSON-CSF**
**173, Boulevard Haussmann**
**F-75379 Paris Cedex 08 (FR)**

(72) Inventeur : **Roche, Marcel**
**"THOMSON-CSF" SCPI 173, Bld Haussmann**
**F-75360 Paris Cedex 08 (FR)**

(74) Mandataire : **de Beaumont, Michel et al**
**THOMSON-CSF SCPI 173, Bld Haussmann**
**F-75379 Paris Cedex 08 (FR)**

Jouve, 18, rue St-Denis, 75001 Paris, France

## Procédé d'auto-alignement de régions différemment dopées d'une structure de semiconducteur, et application du procédé à la fabrication d'un transistor

La présente invention concerne un procédé d'auto-alignement de régions dopées différemment, notamment les régions des émetteurs et des contacts de base en particulier pour la fabrication de transistors et de circuits intégrés.

Dans le domaine de la réalisation de dispositifs à semiconducteurs dotés de performances élevées, concernant par exemple le temps de commutation, le gain en fréquence, le rapport signal/bruit, etc., on est conduit à réduire tous les éléments parasites, ce qui entraîne en général une miniaturisation de plus en plus poussée de tout ou partie des dimensions. Indépendamment des performances, cette miniaturisation est recherchée pour accroître la densité d'intégration dans le cas des circuits intégrés. En ce qui concerne la profondeur, la réduction dans cette direction est conditionnée par la maîtrise des profils de distribution des impuretés dopantes, qui est acquise par exemple au moyen de l'implantation ionique. Mais, en ce qui concerne l'étendue en surface, un facteur limitatif important est la précision que l'on peut espérer du positionnement relatif des ouvertures ménagées dans la structure de base et servant à définir les différentes régions à doper, à savoir les régions des émetteurs et des contacts de base.

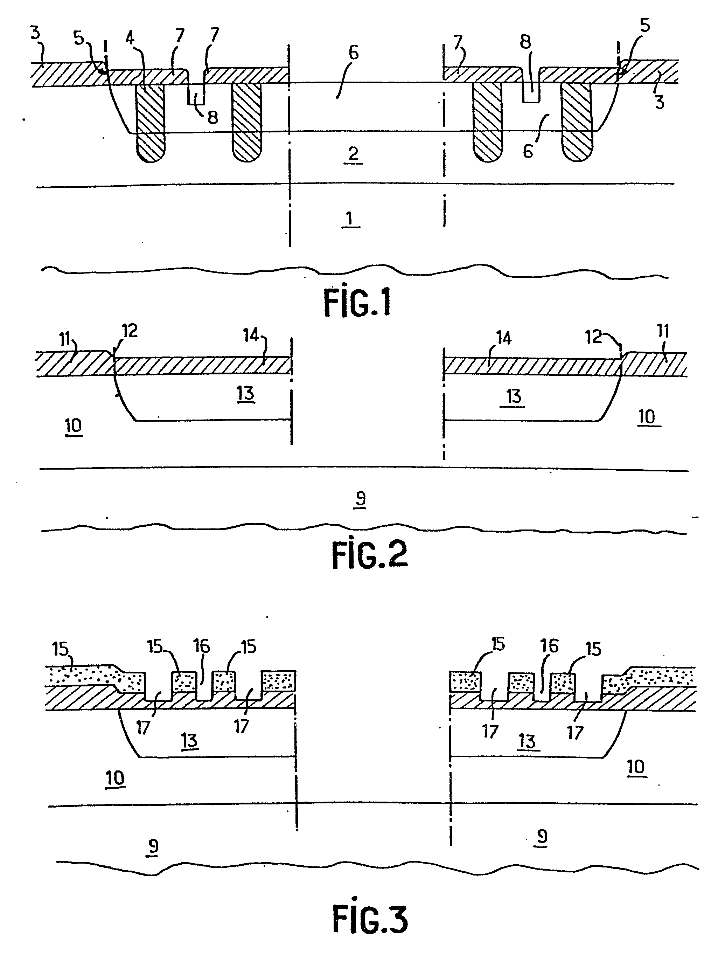

Dans l'art antérieur il est connu d'utiliser à cet effet une technique dite « d'auto-alignement », selon laquelle on réalise un positionnement relatif de deux ouvertures et de régions à dopage différent obtenues à partir de ces ouvertures et ce de manière que les ouvertures ou les régions ne se chevauchent pas, tout en étant situées à une distance relative aussi réduite que possible. Ci-après on va décrire, en référence aux figures 1 à 11 annexées à la présente demande, deux exemples connus de mise en œuvre de cette technique dans le cas de la fabrication d'un transistor hyperfréquence, du type réalisé avec une structure interdigitée classique, selon laquelle l'émetteur du transistor est formé de doigts alternés avec des contacts de base.

Selon une technique classique (figure 1), on dépose sur un substrat 1, par exemple de type n$^+$, une couche épitaxiale de même type (n) 2. Après le dépôt d'une couche de masquage, par exemple une couche d'oxyde 3, on réalise par photogravure des ouvertures, à travers lesquelles on introduit des impuretés de type p de manière à créer des zones faiblement résistives 4, qui sont destinées à recevoir ultérieurement un métal de contact. On réalise alors une autre ouverture 5 dans la couche d'oxyde de masquage 3 et l'on forme la base 6 par implantation ionique ou par diffusion. Ensuite on dépose une nouvelle couche de masquage 7, par exemple d'oxyde, sur la base 6. On réalise alors les régions d'émetteurs 8 par la technique connue de la photogravure, les émetteurs étant alors obtenus par diffusion ou implantation d'impuretés, de type n dans le cas considéré. La fin de la procédure, relative à la photogravure des zones de contact, au dépôt métallique et à la photogravure des interconnexions, est alors mise en œuvre de façon connue et n'est donc pas représentée sur la figure.

Avec la procédure indiquée ci-dessus, la distance que l'on peut obtenir entre les émetteurs ne peut guère être inférieure à 3 μ sans mise en œuvre de la technique d'auto-alignement, qui permet d'abaisser ce chiffre de façon reproductible à 1 μ ou à quelques dixièmes de micron, et donc d'améliorer le facteur de mérite du dispositif, qui dépend entre autre étroitement de cette distance.

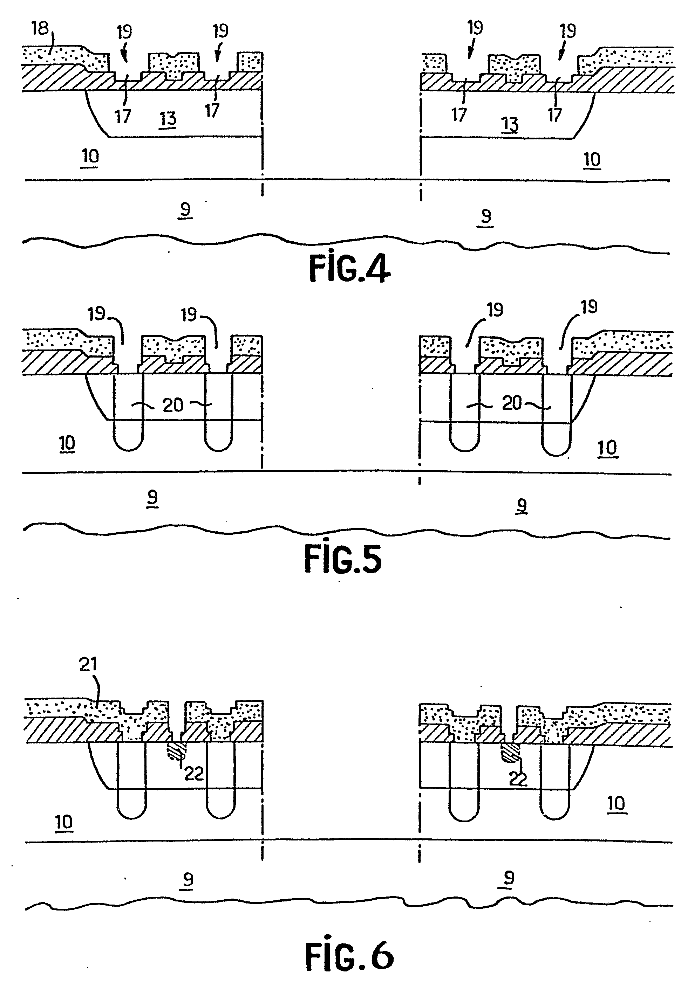

Selon un premier procédé connu sous le nom de masquage composé, on peut réduire cette distance à 2 μ et ce de façon reproductible, en inscrivant toutes les ouvertures, correspondant aux différentes régions à doper, dans un masque « mémoire » et en sélectionnant successivement chacune des ouvertures au moyen d'un masque de sélection. La séquence des opérations est reproduite sur les figures 2 à 5 annexées. Sur un substrat 9 de type n$^+$ par exemple, on dépose une couche épitaxiale de même type 10, et, après formation d'une couche de masquage, par exemple d'oxyde 11, on réalise une ouverture dont les bords sont repérés par 12 et au niveau de laquelle on réalise la base 13 par diffusion ou par implantation d'ions. Ensuite on dépose une couche de masquage 14, par exemple d'oxyde, et l'on aboutit alors à la structure de la figure 2. Puis, à l'aide d'un masque composé 15 (figure 3) comportant les ouvertures 16 pour la réalisation des émetteurs et les ouvertures 17 pour la réalisation des contacts de base, c'est-à-dire comportant les deux types de régions à auto-aligner, on effectue par photolithographie classique une gravure sur environ la moitié de l'épaisseur de la couche 14, au niveau des ouvertures 16 et 17. Ensuite (figure 4) en utilisant un masque 18 de sélection des contacts de base, dont les ouvertures 19 sont plus grandes que leurs homologues 17 du masque composé 15, d'une distance égale au maximum de l'erreur possible de positionnement imputable aux machines et/ou à l'opérateur, on ouvre les régions des contacts de base, ce qui aboutit à la structure représentée sur la figure 5, dans laquelle on effectue alors une diffusion, au niveau des ouvertures, dans les régions 20, après enlèvement du masque 18. La photogravure des émetteurs est réalisée selon le même principe à l'aide d'un masque 21 de sélection des émetteurs 4 (figure 6), dont les ouvertures sont plus grandes que leurs homologues du masque composé, d'une distance encore égale au maximum de l'erreur de positionnement possible, puis on effectue la diffusion du/des émetteurs 22, après élimination du masque 21.

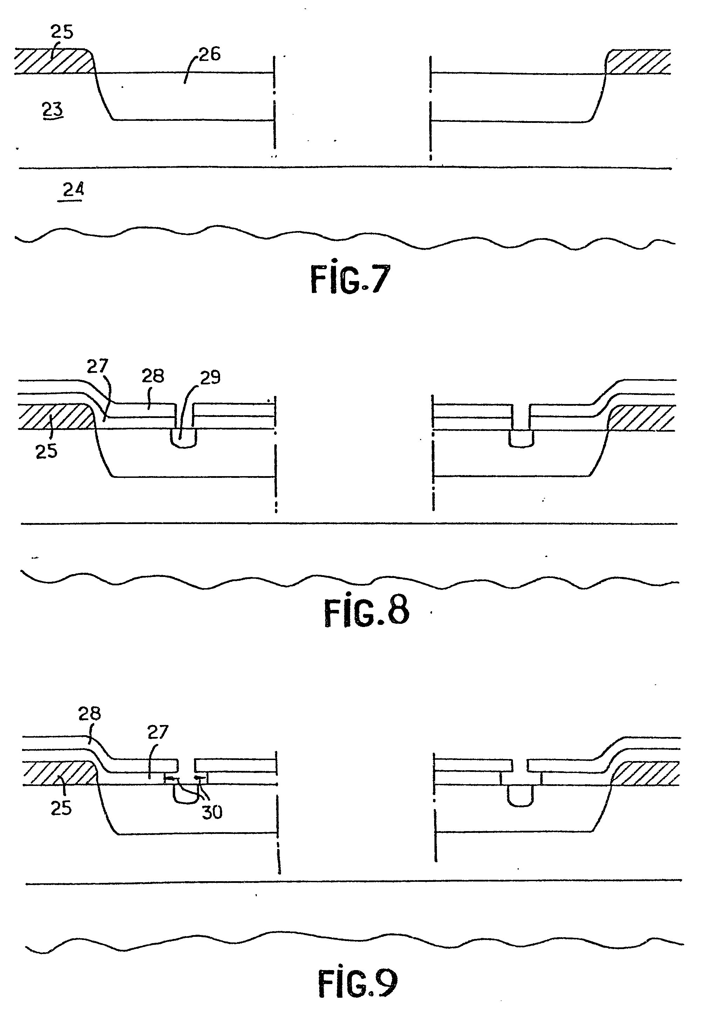

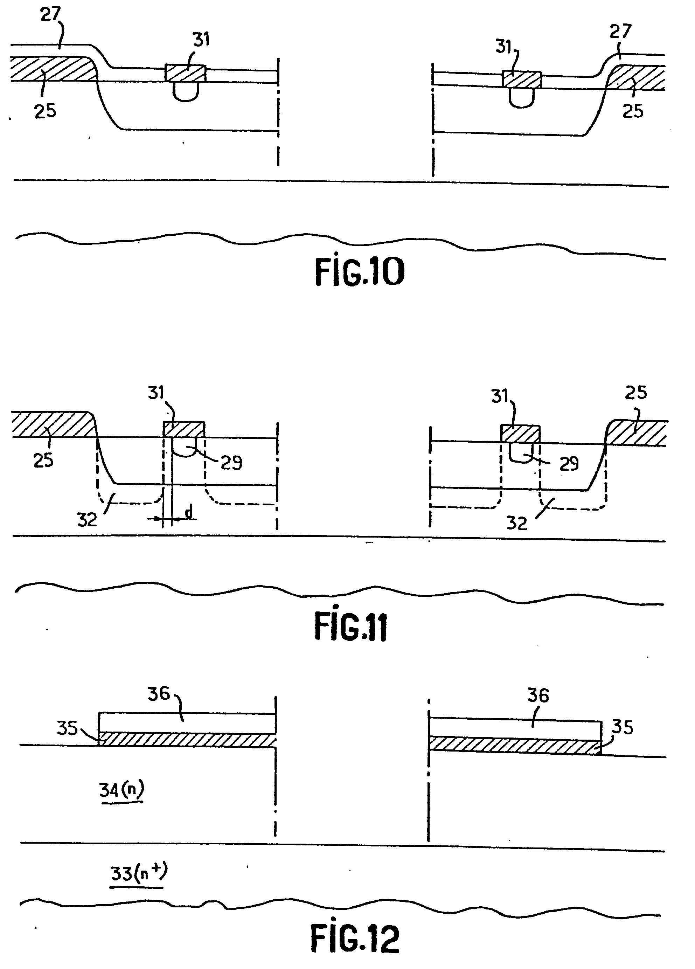

Selon un autre procédé connu d'auto-alignement décrit au brevet U.S. n° 3.951.693, il est possible de ramener la distance entre les régions à doper à quelques dixièmes de micron. La séquence des opérations, illustrée sur les figures 7 à 11 annexées à la présente demande, est la suivante. La formation de la couche épitaxiale 23 sur un substrat 24, la réalisation de la couche de masquage 25, la photogravure et la diffusion de la base 26 s'effectuent de la façon classique déjà indiquée dans l'exemple précédent. Ensuite on dispose une couche de nitrure de silicium 27 et une couche de silice 28, qui sont ensuite photogravées avec un même masque non représenté, comportant les motifs des émetteurs, et l'on implante le ou les émetteurs 29, après enlèvement du masque, conformément à la figure 8. Le nitrure 27 protégé par la couche de silice 28 située au-dessus est gravé latéralement comme indiqué sur la figure 9 (flèches 30). On élimine alors la couche de silice 28 et l'on forme une autre couche de silice 31 (figure 10), par un traitement thermique approprié, sur les zones de silicium non recouvertes par la couche de nitrure 27. Après suppression de cette dernière, on réalise par dopage les régions fortement dopées 32 de type $p^+$ (figure 11), qui se trouvent aussi auto-positionnées par rapport aux émetteurs 29, la distance ou l'espacement repéré par d sur la figure désignant l'écartement des régions différemment dopées 29 et 32 et pouvant être de l'ordre de quelques dixièmes de micron selon cette technique.

Mais, la qualité de l'auto-alignement dépend de la gravure latérale du nitrure. Or la reproductibilité de cette dernière est difficile à maîtriser car elle est liée étroitement à la couche de silice 28, qui elle-même est conditionnée par de nombreux paramètres pouvant fluctuer, comme par exemple le nettoyage avant dépôt des couches de silice et de nitrure, les conditions du dépôt, la qualité des interfaces, etc.

Avec le premier procédé que l'on peut mettre en œuvre de façon reproductible, on ne peut réduire la distance entre régions à auto-aligner qu'à environ 2 μ, alors que le second procédé permet d'abaisser cette distance à quelques dixièmes de micron, mais d'une façon non reproductible.

Il est également connu pour obtenir des masques particuliers d'utiliser le fluage de couches de résine. Par exemple l'abrégé du brevet japonais 53-89366 paru dans Patent Abstracts of Japan Vol 2, n° 124, 18 octobre 1978, page 7230 E 78 décrit un procédé utilisant un masque de résine en forme de champignons pour délimiter une première implantation, la résine étant ensuite amenée à fluer pour définir un deuxième masque utilisé pour effectuer une deuxième implantation de même type que la première à l'intérieur du contour de la première.

Un objet de la présente invention est de prévoir un procédé, utilisant notamment une étape de fluage de résine, pour réaliser dans un substrat de silicium des zones quasi adjacentes dopées de façon distincte.

Le procédé selon la présente invention pour réaliser dans un substrat de silicium l'autoaligne-ment de régions disposées de façon quasi adjacente et dopées de façon distincte, consiste à : revêtir ce substrat de couches successives de silice mince, de nitrure de silicium et de résine photosensible, puis à ouvrir de façon correspondante des fenêtres dans les couches de résine et de nitrure, en maintenant des régions de nitrure surmontées de résine ; faire fluer de façon contrôlée la résine en débordement par rapport aux régions de nitrure, pour définir un premier masque d'implantation ; implanter un dopant d'un premier type de conductivité dans les ouvertures de ce premier masque ; enlever par attaque sélective les couches de résine ; accroître l'épaisseur de la couche mince d'oxyde aux emplacements non recouverts de nitrure ; enlever par attaque sélective des régions de nitrure ; utiliser le deuxième masque défini par les différences d'épaisseur de la couche d'oxyde restante pour introduire un dopant du deuxième type de conductivité.

Un avantage de cette méthode est de ne pas dépendre des conditions d'adhérence entre couches.

A titre d'exemple on a décrit ci-dessous et illustré schématiquement aux dessins annexés un mode d'exécution du procédé conforme à l'invention.

Les figures 1 à 11, dont il a déjà été fait mention, concernent deux techniques d'auto-alignement connues dans l'art antérieur.

Les figures 12 à 17 illustrent les diverses phases de mise en œuvre du procédé conforme à l'invention.

En se référant aux figures 12 à 17, on va décrire l'application non limitative du procédé selon l'invention à un transistor NPN hyperfréquence. Les valeurs numériques indiquées sont données à titre indicatif uniquement.

Sur un substrat 33 de type $n^+$, dont la résistivité est par exemple de l'ordre de $1/100^e \, \Omega \cdot cm$, on réalise une couche épitaxiale 34 de type n, d'une épaisseur de 2 à 4 μ et d'une résistivité comprise entre 0,7 et $2 \, \Omega \cdot cm$ (voir figure 12). Sur cette couche on réalise, par traitement thermique en atmosphère oxydante à une température comprise entre 950 °C et 1 100 °C, une couche de silice 35, dont l'épaisseur est de l'ordre de 500 Å et dont le but essentiel est de réduire les contraintes mécaniques, sources de défauts cristallins, produites lors des traitements thermiques par la présence d'une couche de nitrure de silicium 36 d'une épaisseur d'environ 1 000 Å et un nouveau traitement thermique oxydant transforme la partie supérieure de la couche de nitrure (quelques dizaines d'angstroems) en silice, ce qui permettra des photogravures ultérieures parfaitement définies. Ensuite on effectue une photogravure de différentes couches de diélectrique (silice, nitrure, silice) pour conserver les couches sur la structure de base représentée sur la figure 12. De préférence lors de la photogravure on dissout la silice et le nitrure respectivement dans une solution de FH-FNH$_4$ et dans un plasma de fréon.

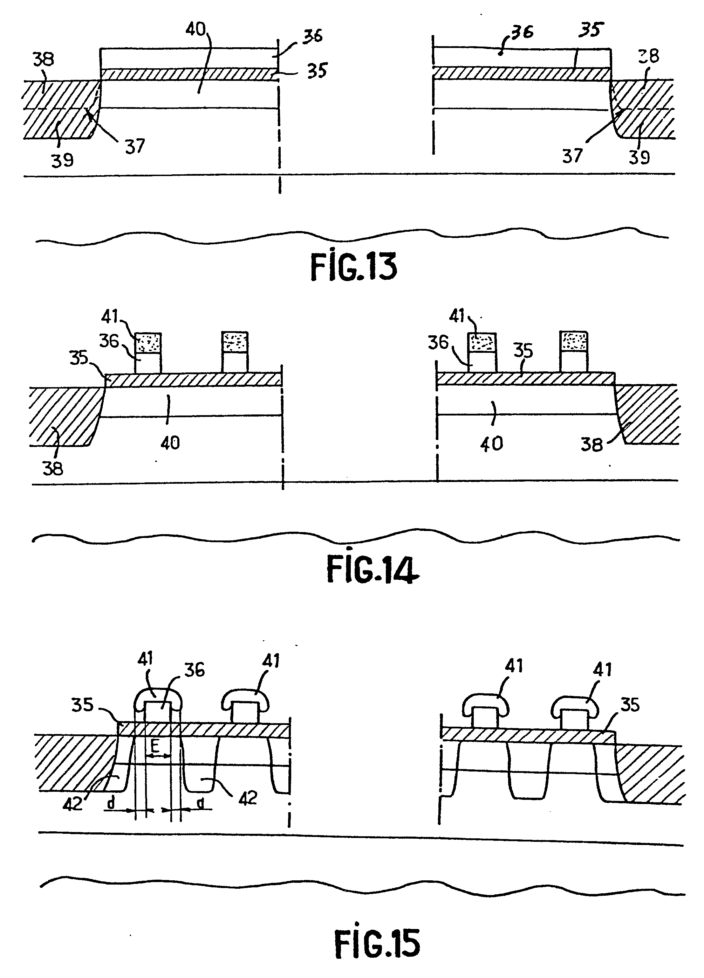

Comme indiqué par une ligne de pointillés 37 sur la figure 13, on retire alors la couche supérieure de silicium 38 d'une épaisseur de l'ordre de 0,6 μ, par dissolution dans une solution à base de FH et de HNO₃. Le silicium mis à nu est alors oxydé pour créer une couche d'oxyde 39 dont l'épaisseur est double de celle de l'évidement 38 ce qui garantit la quasi-planéité de la surface et donc la fiabilité du réseau d'interconnexions, car la majeure partie de ce dernier se trouve éloignée du collecteur en raison de la forte épaisseur d'oxyde, ce qui réduit les capacités parasites. On implante alors la base 40 à travers les couches 35 et 36 en utilisant par exemple des ions de bore avec une dose comprise entre $4 \cdot 10^{13}$ At/cm² et $1,5 \cdot 10^{14}$ At/cm² et une énergie comprise entre 70 kev et 150 kev. Ensuite on réalise une photogravure de la couche de nitrure 36 oxydée en utilisant une résine photosensible 41 de manière à conserver le nitrure au niveau des régions des émetteurs. On aboutit alors à la structure représentée sur la figure 14.

Ensuite, conformément à la figure 15, en conservant les parties de résine photosensible 41, on soumet l'ensemble à un traitement thermique d'une durée comprise entre 20 minutes et 2 heures et égale de préférence à 60 minutes et à une température comprise entre 125 °C et 170 °C et égale de préférence à 150 °C (pour une résine du type AZ111 fabriquée par la firme Shipley) pour amorcer un début de fluage. Ce fluage se poursuit normalement pendant l'implantation, effectuée ensuite et servant à réaliser la zone de base extrinsèque p⁺ 42. Comme on le voit sur la figure 15 on obtient ainsi entre les zones E qui correspondent aux émetteurs proprement dits, réalisés ultérieurement, et les régions latérales de la structure une région de largeur uniforme d de seulement quelques dixièmes de micron, compte tenu de l'épaisseur des résines habituellement utilisées. On peut ajuster cette largeur d par le traitement thermique en mettant en œuvre une chaleur plus ou moins importante. Alors, et ce déjà au cours du traitement thermique pour l'obtention du fluage de la résine, on réalise la zone de base extrinsèque 42 sus-mentionnée par l'implantation ionique permettant d'obtenir un profil optimisé ne fournissant que de faibles résistances parasites. Cette implantation s'effectue à travers la couche de silice 35 en utilisant de préférence des ions de bore et est triple avec pour valeurs indicatives dose/énergie, dans l'ordre d'exécution : $3 \cdot 10^{15}$ At/cm²/80 kev, $10^{15}$ At/cm²/50 kev et $3 \cdot 10^{14}$ At/cm²/25 kev. Cette triple implantation fournit un profil de dopage dont la variation est fonction de la distance à la périphérie de l'émetteur et assure le meilleur compromis faible résistance/haute efficacité d'injection.

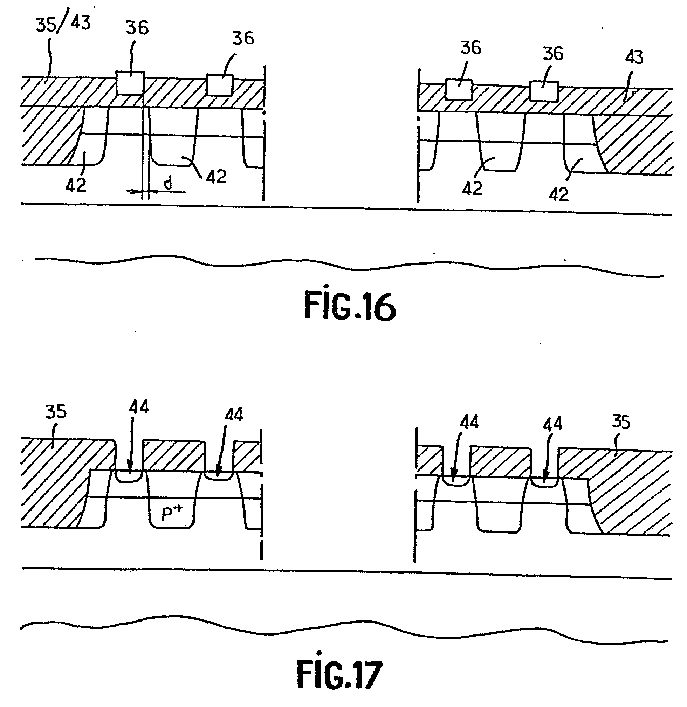

Ensuite on dissout la résine de masquage 41 dans un plasma d'oxygène et l'on accroît la couche de silice 35 pour obtenir une couche finale de silice 43, dans les régions non recouvertes par le nitrure 36, au moyen d'un traitement oxydant servant également à la restauration du silicium et l'on obtient la structure de la figure 16. On notera que ce traitement oxydant se traduit également par une légère oxydation latérale du silicium sous les éléments ou îlots de nitrure 36 et donc il se produit une légère consommation du silicium situé au-dessous des îlots de nitrure et, par suite, un léger rétrécissement de la largeur des régions du/des émetteurs, et donc un léger accroissement de d, dont il faut tenir compte lors du fluage antérieur. A titre d'exemple l'épaisseur totale de la couche de silice 43 est de l'ordre de 2 000 Å. Après élimination des îlots de nitrure 36 par dissolution dans une solution d'acide orthophosphorique bouillant, ainsi que de la couche de silice sous-jacente par désoxydation partielle, on réalise les émetteurs 44 par implantation d'ions arsenic par exemple, avec une dose comprise entre $3 \cdot 10^{15}$ At/cm² et $6 \cdot 10^{15}$ At/cm² et une énergie de l'ordre de 80 kev (voir figure 17). Un nouveau traitement thermique compris entre 920 °C et 970 °C assure la régénération du silicium. Le ou les émetteurs se trouvent ainsi auto-positionnés par rapport aux régions p⁺ 42 de base extrinsèque, à une distance de quelques dixièmes de micron. Ensuite on effectue la photogravure des contacts de base dans les régions p⁺ 42 et on réalise enfin le réseau d'interconnexions selon l'une des techniques classiques bien connues.

On notera que l'auto-alignement ainsi obtenu des émetteurs par rapport aux régions de base extrinsèque est en outre ajustable par réglage de la chaleur apportée pour l'opération de fluage et de la durée de cette dernière.

**Revendications**

1. Procédé pour réaliser dans un substrat de silicium l'autoalignement de régions disposées de façon quasi adjacente et dopées de façon distincte, consistant à revêtir ce substrat de couches successives de silice mince, de nitrure de silicium et de résine photosensible, puis à ouvrir de façon correspondante des fenêtres dans les couches de résine et de nitrure, en maintenant des régions de nitrure surmontées de résine, caractérisé en ce qu'il comprend ensuite les étapes consistant à :

    a) faire fluer de façon contrôlée la résine en débordement par rapport aux régions de nitrure, pour définir un premier masque d'implantation ;

    b) implanter un dopant d'un premier type de conductivité dans les ouvertures de ce premier masque ;

    c) enlever par attaque sélective les couches de résine ;

    d) accroître l'épaisseur de la couche mince d'oxyde aux emplacements non recouverts de nitrure ;

    e) enlever par attaque sélective les régions de nitrure ;

    f) utiliser le deuxième masque défini par les différences d'épaisseur de la couche d'oxyde restante pour introduire un dopant du deuxième type de conductivité.

2. Procédé selon la revendication 1 pour réaliser l'autoalignement de régions d'émetteurs et de bases pour la fabrication de transistors, caractérisé en ce que le premier masque d'implantation sert à implanter des régions de contact de base, les zones situées sous les régions de nitrure correspondant sensiblement aux zones d'émetteur.

3. Procédé selon la revendication 1 caractérisé en ce que, après l'étape e, il comprend l'étape consistant à attaquer de façon limitée la couche d'oxyde pour mettre à nu le substrat de silicium en des emplacements correspondant à ceux occupés précédemment par les régions de nitrure.

4. Procédé suivant la revendication 1, caractérisé par le fait que le fluage de la résine est réalisé sous l'effet d'un traitement thermique et ensuite conjointement sous l'effet du bombardement d'ions lors de l'implantation ionique.

5. Procédé suivant la revendication 4, caractérisé par le fait que le traitement thermique s'effectue entre 125 °C et 170 °C et de préférence à 150 °C pendant une durée comprise entre 20 minutes et 2 heures, et de préférence pendant 60 minutes.

6. Procédé suivant l'une des revendications 4 ou 5, caractérisé par le fait que l'implantation ionique est une implantation triple d'ions bore avec des couples dose/énergie consécutifs ayant des valeurs de l'ordre de $3 \cdot 10^{15}$ At/cm$^2$-80 kev, $10^{15}$ At/cm$^2$-50 kv, $3 \cdot 10^{14}$ At/cm$^2$-25 kev.

7. Procédé suivant la revendication 3, caractérisé par le fait qu'on règle l'écartement d'autoalignement des régions dopées différemment en modifiant les caractéristiques du traitement thermique de fluage.

8. Application du procédé suivant l'une quelconque des revendications 1 à 7, à la fabrication d'un transistor hyper-fréquence.

**Claims**

1. A process of obtaining in a silicon substrate the self-alignment of substantially adjacent and differently doped regions, comprising the steps of covering said substrate with successive layers of thin silica, silicon nitride and light-sensitive resin, and then correspondingly opening windows in the resin and nitride layers while maintaining nitride regions covered with resin, characterized in that it comprises the subsequent steps of :

a) causing the resin to flow in a controlled manner with overlapping with respect to the nitride regions, for defining a first implantation mask ;

b) implanting a doping substance having a first type of conductivity in the openings of this first mask ;

c) withdrawing by selective attack the resin layers ;

d) increasing the thickness of the thin oxide layer at the locations not covered with nitride ;

e) removing the nitride regions by selective attack ;

f) using the second mask defined by the thickness differences of the remaining oxide layer for introducing a doping substance having a second type of conductivity.

2. A process according to claim 1, for achieving self-alignment of emitter and base regions when manufacturing transistors, characterized in that the first implantation mask serves to implant base contact regions, while the zones located beneath the nitride regions correspond substantially to the emitter zones.

3. A process according to claim 1, characterized in that, after step e), it comprises a further step consisting in attacking in a limited manner the oxide layer for denuding the silicon substrate at locations corresponding to those previously occupied by the nitride regions.

4. A process according to claim 1, characterized in that the step of causing the resin to flow is carried out under the effect of a thermal treatment and conjointly under the effect of ion bombardment during the ion implantation.

5. A process according to claim 4, characterized in that the thermal treatment is carried out at a temperature comprised between 125 °C and 170 °C, preferably a temperature of 150 °C, during a time period comprised between 20 minutes and 2 hours, preferably a time period of 60 minutes.

6. A process according to claim 4 or 5, characterized in that the ion implantation is a treble boron ion implantation with pairs of values ranging about $3 \cdot 10^{15}$ At/cm$^2$-80 kev, $10^{15}$ At/cm$^2$-50 kv, $3 \cdot 10^{14}$ At/cm$^2$-25 kev.

7. A process according to claim 3, characterized in that the self-alignment spacing of the differently doped regions is adjusted by varying the characteristics of the flowing thermal treatment.

8. Any application of the process according to any one of claims 1 to 7, in the field of manufacturing hyper-frequency transistors.

**Ansprüche**

1. Verfahren zum selbsttätigen Ausrichten wesentlich benachbarter und unterschiedlich dotierter Zonen in einer Siliziumträgerschicht, bei dem diese Trägerschicht mit aufeinanderfolgenden Schichten aus dünnem Siliziumdioxyd, Siliziumnitrid und lichtempfindlichem Harz bedeckt wird, wonach man entsprechende Fenster in den Harz- und Nitridschichten öffnet und dabei die mit Harz bedeckten Nitridschichten beibehält, dadurch gekennzeichnet, dass es die nachfolgenden Verfahrensschritte umfasst :

a) Fliessenlassen des Harzes unter gesteuerten Bedingungen mit Überlappung in bezug auf die Nitridzonen, um eine erste Einpflanzmaske abzugrenzen ;

b) Einpflanzung eines Dotiermittels mit einem ersten Leitfähigkeitstyp in die Öffnungen dieser ersten Maske ;

c) Entfernen der Harzschichten durch selektives Korrodieren ;

d) Erhöhen der Dicke der dünnen Oxydschicht an den nicht von Nitrid abgedeckten Stellen ;

e) Entfernen der Nitridzonen durch selektives Korrodieren ;

f) Verwendung der zweiten durch die Dickenunterschiede der verbleibenden Oxydschicht gebildeten Maske, zwecks Einführung eines Dotiermittels mit einem zweiten Leitfähigkeitstyp.

2. Verfahren nach Anspruch 1 zum selbsttätigen Ausrichten von Emitter- und Basiszonen bei der Herstellung von Transistoren, dadurch gekennzeichnet, dass die erste Einplanzungsmaske zum Einpflanzen der Basiskontaktzonen dient, während die unterhalb der Nitridzonen gelegenen Zonen wesentlich den Emitterzonen entsprechen.

3. Verfahren nach Anspruch 1, dadurch gekennzeichnet, dass nach dem Verfahrensschritt e) ein Verfahrensschritt durchgeführt wird, der darin besteht, in begrenzter Weise die Oxydschicht zu korrodieren, um die Siliziumträgerschicht an den zuvor mit den Nitridzonen bedeckten Zonen entsprechenden Stellen offenzulegen.

4. Verfahren nach Anspruch 1, dadurch gekennzeichnet, dass das Harz durch eine Wärmebehandlung und sodann gleichzeitig durch Ionenbombardement während der Ioneneinpflanzung zum Fliessen gebracht wird.

5. Verfahren nach Anspruch 4, dadurch gekennzeichnet, dass die Wärmebehandlung bei einer Temperatur von 125 °C bis 170 °C, vorzugsweise von 150 °C während einer Dauer von 20 minuten bis 2 Stunden, vorzugsweise 60 Minuten durchgeführt wird.

6. Verfahren nach Anspruch 4 oder 5, dadurch gekennzeichnet, dass die Ioneneinpflanzung eine dreifache Bor-Ioneneinpflanzung ist, mit aufeinanderfolgenden Dosis/Energie = Wertepaaren von etwa $3 \cdot 10^{15}$ At/cm$^2$-80 kev, $10^{15}$ At/cm$^2$-50 kv, $3 \cdot 10^{14}$ At/cm$^2$-25 kev.

7. Verfahren nach Anspruch 3, dadurch gekennzeichnet, dass man den Abstand der selbsttätigen Ausrichtung der unterschiedlich dotierten Zonen durch Änderung der Kennwerte der Wärmefliessbehandlung einstellt.

8. Anwendung des Verfahrens nach einem der Ansprüche 1 bis 7 auf die Herstellung eines Hyperfrequenztransistors.

FIG.1

FIG.2

FIG.3

FIG.4

FIG.5

FIG.6

FIG.7

FIG.8

FIG.9

FIG.10

FIG.11

FIG.12

FIG.13

FIG.14

FIG.15

**FIG.16**

**FIG.17**